(19) Europäisches Patentamt
European Patent Office
Office européen des brevets

(11) Veröffentlichungsnummer: **0 141 110**
**B1**

(12) # EUROPÄISCHE PATENTSCHRIFT

(45) Veröffentlichungstag der Patentschrift: **22.04.87**

(51) Int. Cl.⁴: **C 08 F 2/50,** G 03 C 1/68

(21) Anmeldenummer: **84110004.3**

(22) Anmeldetag: **22.08.84**

(54) **Photopolymerisierbare Mischungen, enthaltend tertiäre Amine als Photaktivatoren.**

(30) Priorität: **30.08.83 DE 3331157**

(43) Veröffentlichungstag der Anmeldung:
**15.05.85 Patentblatt 85/20**

(45) Bekanntmachung des Hinweises auf die Patenterteilung:
**22.04.87 Patentblatt 87/17**

(84) Benannte Vertragsstaaten:
**BE CH DE FR GB IT LI NL SE**

(56) Entgegenhaltungen:
**EP - A - 0 045 494**

(73) Patentinhaber: **BASF Aktiengesellschaft,**
***Carl-Bosch-Strasse 38, D-6700 Ludwigshafen (DE)***

(72) Erfinder: **Henne, Andreas, Dr.,**
**Adolf-Kolping-Strasse 137 a, D-6730 Neustadt (DE)**
Erfinder: **Jacobi, Manfred, Dr., Heidelberger Ring 32 B,**
**D-6710 Frankenthal (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 141 110 B1

ACTORUM AG

**Beschreibung**

Die Erfindung betrifft photopolymerisierbare Mischungen, die mindestens eine photopolymerisierbare, olefinisch ungesättigte Verbindung, mindestens einen Photoinitiator bzw. -sensibilisator, mindestens einen Photoaktivator sowie gegebenenfalls weitere Zusatz- und/oder Hilfsstoffe enthalten.

Photopolymerisierbare Mischungen der in Rede stehenden Art sind bekannt. Sie enthalten als Photoinitiatoren bzw. -sensibilisatoren in der Regel Arylketone, die sich vom Grundkörper der Benzophenone, Acetophenone, Benzoine, Benzile, Benzilmonoketale, des Fluorenons oder Thioxanthons durch geeignete Substitution ableiten. Ferner sind auch Acylphosphinoxidverbindungen als Photoinitiatoren beschrieben. Bei Bestrahlung der photopolymerisierbaren Mischungen mit aktinischem Licht initiieren die Photoinitiatoren bzw. -sensibilisatoren die Polymerisation der polymerisierbaren, olefinisch ungesättigten Verbindungen.

Die Geschwindigkeit dieser Photohärtung der photopolymerisierbaren Gemische lässt sich durch Zusatz von geeigneten Aktivatoren für die Photoinitiatoren bzw. -sensibilisatoren beschleunigen. Als Aktivatoren werden dabei insbesondere Aminverbindungen eingesetzt (vgl. z.B. US-A-3759807, DE-A-2602419, DE-A-2003132, DE-A-2317945, DE-A-2251048, DE-A-2522756, EP-A-12949 und EP-A-1466). Technisch finden vor allem Hydroxyalkylamine, wie Methyldiethanolamin, Triethanolamin oder Derivate der 2-Bis-(β-Hydroxyethyl)-aminopropionsäure, die in der EP-A-2625 beschriebenen ω-(Dialkylamino)-alkyl-benzoate sowie die in der EP-A-3872 beschriebenen Ester der p-Dialkylaminobenzoesäure Verwendung.

Ein Nachteil der Alkanolamine besteht darin, dass sie die Lagerstabilität der damit ausgerüsteten photopolymerisierbaren Mischung stark reduzieren. Ein weiterer Nachteil ist in dem Ausschwitzen dieser Amine aus den gehärteten Produkten, beispielsweise Lackfilmen, zu sehen, die dadurch unansehnlich werden. Während ω-(Dialkylamino)-alkylbenzoate sowie p-Dialkylaminobenzoate photopolymerisierbare Mischungen mit befriedigender Lagerstabilität ergeben, führt der Zusatz solcher Verbindungen zu photopolymerisierbaren Mischungen zu einer unerwünschten und häufig nicht zu akzeptierenden Vergilbung der damit hergestellten Produkte. Es besteht somit ein Bedarf an Aktivatoren, die diese Nachteile nicht aufweisen.

Aufgabe der vorliegenden Erfindung war es, Aktivatoren enthaltende photopolymerisierbare Gemische aufzuzeigen, die eine verbesserte Lagerstabilität und hohe Härtungsgeschwindigkeiten aufweisen und die nach der Photohärtung nicht vergilben und kein Ausschwitzen irgendwelcher Bestandteile zeigen.

Es wurde nun überraschend gefunden, dass diese Aufgabe gelöst wird, wenn die photopolymerisierbaren Mischungen als Aktivatoren solche tertiären Amine enthalten, die am Stickstoff mindestens eine Ethylgruppe tragen, die in 2-Stellung, wie nachfolgend definiert, trisubstituiert ist.

Gegenstand der Erfindung sind dementsprechend photopolymerisierbare Mischungen, die

(a) mindestens eine Verbindung mit mindestens einer photopolymerisierbaren, olefinisch ungesättigten Doppelbindung,

(b) mindestens einen Photoinitiator bzw. -sensibilisator,

(c) ein oder mehrere tertiäre Amine als Aktivator sowie gegebenenfalls

(d) weitere übliche Zusatz- und/oder Hilfsstoffe

enthalten und welche dadurch gekennzeichnet sind, dass sie als Aktivator (c) ein tertiäres Amin der allgemeinen Formel (I)

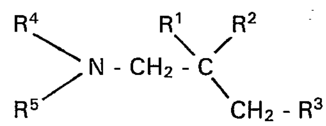

(I)

enthalten, worin stehen

$R^1$, $R^2$: unabhängig voneinander für einen gegebenenfalls hydroxy- oder alkoxy-substituierten niederen Alkylrest, einen gegebenenfalls hydroxy- oder alkoxy-substituierten Cycloalkylrest, einen gegebenenfalls alkyl- oder alkoxy-substituierten Phenylrest, eine Hydroxylgruppe oder eine niedere Alkoxy-Gruppe oder $R^1$ und $R^2$ gemeinsam unter cyclischer Verknüpfung für einen Alkylenrest;

$R^3$: für einen Rest mit der Bedeutung von $R^1$ oder $R^2$, ein Wasserstoffatom, einen Acyloxy-Rest oder einen alkyl-, alkoxy-, halogen- und/oder dialkylamino-substituierten Benzoyloxyrest; sowie

$R^4$, $R^5$: unabhängig voneinander für einen gegebenenfalls hydroxy-substituierten niederen Alkylrest, einen gegebenenfalls hydroxy-substituierten Cycloalkylrest oder einen gegebenenfalls alkyl- oder alkoxy-substituierten Phenylrest oder $R^4$ und $R^5$ gemeinsam unter cyclischer Verknüpfung für einen Alkylenrest oder einen Alkylenoxyalkylen-Rest.

Gegenstand der Erfindung ist ferner die Verwendung dieser, die speziellen Amin-Aktivatoren enthaltenden, photopolymerisierbaren Massen zur Herstellung von Lacken, Überzügen, photopolymeren Druck- oder Reliefformen, Resistschichten oder -mustern, UV-härtenden Druckfarben, Formkörpern oder Imprägnierungen.

Bei den erfindungsgemäss in den photopolymerisierbaren Mischungen als Aktivator (c) enthaltenen tertiären Aminen handelt es sich allgemein um tertiäre Ethylamine, die in der 2-Stellung der Ethylgruppe trisubstituiert sind. Die hohe Lagerstabilität der mit den erfindungsgemässen Aktivatoren ausgerüsteten photopolymerisierbaren Mischungen war insofern überraschend, als photopolymerisierbare Gemische, die in 2-Stellung der Ethylgruppe nicht oder mono-substituierte Ethyldialkylamine als Aktivatoren enthalten, sich durch schlechte Lagerstabilität auszeichnen. Die erfindungsgemässen photopolymerisierbaren Mischungen zeigen im Vergleich zu anderen Amin-Aktivatoren enthaltenden lichthärtbaren Massen, z.T. auch eine erhöhte Härtungsgeschwindigkeit bei der Belichtung und eine verbesserte Vergilbungsstabilität der gehärteten Produkte. Die erfindungsgemässen photopolymerisierbaren Massen besitzen somit eine ausgewogene und optimale

Eigenschaftskombination bezüglich der für solche Mischungen kritischen und wichtigen Eigenschaften.

Als Amin-Aktivatoren (c) sind die in 2-Stellung und am Stickstoffatom jeweils disubstituierten 1-Aminopropane zu nennen. Bezüglich der allgemeinen Formel (I) ist im einzelnen folgendes auszuführen:

$R^1$ und $R^2$ können gleich oder verschieden sein und jeder für sich ein geradkettiger oder verzweigter Alkylrest mit insbesondere 1 bis 6 C-Atomen, wie Methyl, Ethyl, n-Propyl, i-Propyl, n-Butyl, Amyl oder n-Hexyl; ein durch Hydroxylgruppen oder Alkoxy-Gruppen mit 1 bis 6 C-Atomen substituierter Alkylrest mit 1 bis 6 C-Atomen, wie 2-Hydroxyethyl, 2--Hydroxypropyl, 3-Hydroxypropyl, 4-Hydroxybutyl, Methoxyethyl, Ethoxyethyl, Methoxypropyl, Ethoxypropyl, Methoxybutyl oder Ethoxybutyl; ein Cycloalkylrest, insbesondere mit 5 oder 6 C-Atomen, wie Cyclopentyl oder Cyclohexyl; ein durch Hydroxylgruppen oder Alkoxygruppen insbesondere mit 1 bis 6 C-Atomen substituierter Cycloalkylrest, insbesondere Cyclopentyl- oder Cyclohexylrest; ein Phenylrest oder ein durch Alkyl- oder Alkoxy-Reste insbesondere mit 1 bis 6 C-Atomen substituierter Phenylrest, wie z.B. Methylphenyl, Ethylphenyl, Isopropylphenyl, tert.Butylphenyl, Dimethylphenyl, Methoxyphenyl, Ethoxyphenyl oder Dimethoxyphenyl; eine Alkoxygruppe insbesondere mit 1 bis 6 C-Atomen, wie Methoxy, Ethoxy, Propoxy, Butoxy, oder der $CH_3$-$(CH_2)_5$-O-Rest, oder eine Hydroxylgruppe. $R^1$ und $R^2$ können auch zu einem Ring verbunden sein und stellen dann zusammen einen Alkylenrest dar, wie insbesondere -$(CH_2)_n$- mit $n = 4$ oder 5.

$R^3$ kann die Bedeutung von $R^1$ oder $R^2$ haben (mit Ausnahme des Falles, wenn $R^1$ und $R^2$ unter Ringbildung miteinander verbunden sind), wobei die Reste $R^1$, $R^2$ und $R^3$ unabhängig voneinander sind und untereinander gleich oder verschieden sein können; und kann ferner sein ein Wasserstoffatom; eine Acyloxygruppe, wie insbesondere die $OR^6$-Gruppe, worin $R^6$ für einen geradkettigen oder verzweigten Acylrest, insbesondere mit 1 bis 18 C-Atomen, steht und dieser Acylrest gegebenenfalls in α,β-Stellung zur Carbonylgruppe eine Doppelbindung tragen kann, wie z.B. Acryloyl, Methacryloyl oder Stearoyl; oder ein Benzoyloxyrest, der durch eine oder mehrere Halogenatome, wie z.B. Chlor, Alkylgruppen insbesondere mit 1 bis 6 C-Atomen, z.B. Methyl, Ethyl, Isopropyl oder tert.Butyl, Alkoxygruppen mit insbesondere 1 bis 6 C-Atomen, z.B. Methoxy oder Ethoxy, oder durch eine Di-($C_1$-$C_6$-Alkyl)aminogruppe, z.B. Dimethylamino oder Diethylamino, kernsubstituiert ist.

$R^4$ und $R^5$ können gleich oder verschieden und jeder für sich sein ein geradkettiger oder verzweigter Alkylrest, insbesondere mit 1 bis 6 C-Atomen, wie Methyl, Ethyl, n-Propyl, i-Propyl, n-Butyl, Amyl oder n-Hexyl; ein durch Hydroxygruppen substituierter Alkylrest insbesondere mit 1 bis 6 C-Atomen, wobei die Hydroxygruppe vorzugsweise in β-Stellung steht, wie z.B. β-Hydroxyethyl oder β-Hydroxypropyl; ein Cycloalkylrest insbesondere mit 5 oder 6 C-Atomen, wie Cyclopentyl oder Cyclohexyl, der gegebenenfalls durch Hydroxygruppen substituiert sein kann; ein Phenylrest oder ein durch Alkyl- oder Alkoxygruppen insbesondere mit 1 bis 6 C-Atomen substituierter Phenylrest, wie Methylphenyl, Ethylphenyl, Isopropylphenyl, tert.-Butylphenyl, Dimethylphenyl, Methoxyphenyl, Ethoxyphenyl oder Dimethoxyphenyl. $R^4$ und $R^5$ können auch miteinander zu einem Ring verbunden sein und dabei zusammen insbesondere eine Alkylengruppe, wie die -$(CH_2)_n$--Gruppe mit $n = 4$ oder 5, d.h. Tetramethylen oder Pentamethylen, oder auch einen Alkylenoxyalkylen-Rest, insbesondere den -$(CH_2)_2$-O-$(CH_2)_2$-Rest, bedeuten.

Vorzugsweise stellen in der allgemeinen Formel (I) die Reste $R^1$ und $R^2$ eine, gegebenenfalls durch die oben angeführten Reste substituierte, Alkyl- oder Phenylgruppe dar, insbesondere aber eine Alkyl-Gruppe und ganz besonders bevorzugt Methyl. $R^3$ ist bevorzugt ein Wasserstoffatom, eine Hydroxylgruppe, eine Alkoxygruppe der in Rede stehenden Art oder eine Acyloxygruppe, insbesondere jedoch eine Hydroxylgruppe. Die Reste $R^4$ und $R^5$ stehen vorzugsweise für eine Alkylgruppe, insbesondere Methyl oder Ethyl, gemeinsam für eine Tetramethylen- oder Pentamethylen-Gruppe sowie ganz besonders bevorzugt für einen in 2-Stellung durch eine Hydroxylgruppe substituierten Alkylrest, insbesondere β-Hydroxyethyl oder β-Hydroxypropyl, oder die Methylgruppe.

Als Beispiele für geeignete und bevorzugte Aktivatoren (c) seien genannt: 1-Dimethylamino-2-phenyl--2-methylpropan, 1-Dimethylamino-3-methoxy-2,2--dimethylpropan, 1-Dimethylamino-3-acetoxy-2,2--dimethylpropan, 1-Diethylamino-3-isopropyloxy--2,2-dimethylpropan, 3-N,N-Pentamethylen-2,2-dimethylpropanol-1, 1-Dimethylamino-3-acryloyloxy--2,2-dimethylpropan, 1-Dimethylamino-3-methacryloyloxy-2,2-dimethylpropan, 1-Dimethylamino--3-benzoyloxy-2,2-dimethylpropan, 1-Dimethylamino-3-p-dimethylaminobenzoyl-2,2-dimethylpropan. Besonders geeignet sind 3-Bis-(2'-hydroxyethyl)--amino-2,2-dimethylpropanol-1, 3-Bis-(2'-hydroxypropyl)amino-2,2-dimethylpropanol-1 sowie insbesondere 3-Dimethylamino-2,2-dimethylpropanol-1.

Die erfindungsgemäss als Aktivatoren (c) in den photopolymerisierbaren Mischungen enthaltenen tertiären Aminverbindungen sind als solche bekannt bzw. nach üblichen und in der Literatur beschriebenen Verfahren erhältlich. Sie können in den photopolymerisierbaren Mischungen allein oder in Mischung miteinander enthalten sein. Im allgemeinen sind die Aktivatoren (c) in den photopolymerisierbaren Mischungen in Mengen von 0,1 bis 20 Gew.-%, vorzugsweise von 1 bis 10 Gew.-%, bezogen auf die photopolymerisierbaren, olefinisch ungesättigten Verbindungen (a), enthalten.

Als Photoinitiatoren bzw. -sensibilisatoren (b), mit denen die erfindungsgemäss einzusetzenden Aktivatoren (c) in den photopolymerisierbaren Mischungen zusammenwirken, kommen die für lichthärtbare Massen üblichen und an sich bekannten Photoinitiatoren bzw. -sensibilisatoren in Betracht. Hierzu gehören insbesondere die als Photoinitiator bzw. -sensibilisator wirksamen Verbindungen der allgemeinen Formel (II)

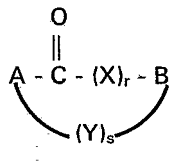

(II).

In der allgemeinen Formel (II) bedeuten:

r, s: die Zahlen 0 oder 1 mit der Massgabe, dass für den Fall s = 0 r = 0 oder 1 ist und für den Fall s = 1 r = 0 ist;

A: einen Phenylrest, der gegebenenfalls durch Alkylgruppen mit 1 bis 6 C-Atomen, Alkoxygruppen mit 1 bis 6 C-Atomen, Alkylthiogruppen mit 1 bis 6 C-Atomen, Bis-($C_1$-$C_6$-alkyl)aminogruppen oder Halogenatome 1- bis 4fach substituiert sein kann;

X: eine Carbonylgruppe -C(O)- oder eine -$CR^7R^8$-Gruppe (wobei $R^7$ und $R^8$ gleich oder verschieden sein können und für ein Wasserstoffatom, eine Hydroxylgruppe, eine Alkylgruppe mit 1 bis 6 C-Atomen, eine Alkoxygruppe mit 1 bis 6 C-Atomen, eine Arylalkoxygruppe, oder eine α-Hydroxymethylgruppe oder $R^7$ und $R^8$ zusammen für einen Alkylenrest-$(CH_2)_n$- mit n = 4 bis 6 oder eine -O-$CH_2$-O-$CH_2$-Gruppe stehen);

B: einen gegebenenfalls 1- bis 4fach durch Alkylgruppen mit 1 bis 6 C-Atomen, Alkoxygruppen mit 1 bis 6 C-Atomen, Alkylthiogruppen mit 1 bis 6 C-Atomen, Bis-($C_1$-$C_6$-alkyl)aminogruppen oder Halogenatome substituierten Phenylrest; einen Alkylrest mit 1 bis 6 C-Atomen, wobei in diesem Fall, falls vorhanden, die Gruppe X keine Carbonylgruppe sein soll; einen Hydroxylrest mit der Massgabe, dass in diesem Fall r = 1 ist und die Gruppe X den -$CR^7R^8$-Rest darstellt; oder eine Gruppierung der allgemeinen Formel (III)

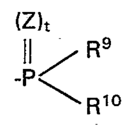

(III)

mit der Massgabe, dass in diesem Fall r = 0 und s = 0 ist, wobei Z für ein Sauerstoffatom oder ein Schwefelatom und t für die Zahlen 0 oder 1 stehen und die Reste $R^9$ und $R^{10}$ die nachfolgend angegebene Bedeutung haben;

Y: für den Fall s = 0 je ein Wasserstoffatom in den Gruppen A und B; und für den Fall s = 1 eine direkte chemische Bindung oder eine -C(O)-, -S-, -O- oder -NH-Gruppierung, die die Gruppen A und B in ortho-Stellung zur Carbonylgruppe miteinander verknüpft.

In der Gruppierung der allgemeinen Formel (III) steht $R^9$ für einen geradkettigen oder verzweigten Alkylrest mit vorzugsweise 1 bis 6 C-Atomen, einen Cycloalkylrest insbesondere mit 5 oder 6 C-Atomen oder einen gegebenenfalls durch Fluor, Chlor, Brom, Alkyl- oder Alkoxy-Gruppen mit 1 bis 4 C-Atomen substituierten Phenyl-, Naphthyl- oder 5- oder 6-gliedrigen heterocyclischen Rest, wobei ein heterocyclischer Rest als Heteroatome vorzugsweise O, S oder N enthält. $R^{10}$ hat die Bedeutung von $R^9$, wobei $R^9$ und $R^{10}$ gleich oder verschieden sein können, oder $R^{10}$ steht für einen Alkoxyrest mit 1 bis 6 C-Atomen, einen gegebenenfalls mit Alkyl- oder Alkoxygruppen mit 1 bis 6 C-Atomen substituierten Phenoxyrest oder einen Phenoxyalkylrest mit 1 bis 4 C-Atomen in der Alkylgruppe.

Eine Gruppe von geeigneten Photoinitiatoren bzw. -sensibilisatoren sind beispielsweise Benzoin und die Benzoin-Derivate, wie sie z.B. in den US-Patentschriften 2367661, 2722512 und 2448828 sowie den deutschen Auslegeschriften 1694149, 1769853 und 1769854 beschrieben sind. Hierzu gehören unter anderem Benzoin selber, Benzoinalkylether, insbesondere mit 1 bis 8 C-Atomen im Alkylrest, wie Benzoin-methylether oder Benzoin-isopropylether; α-Hydroxymethylbenzoin und dessen Alkylether insbesondere mit 1 bis 8 C-Atomen im Alkylrest, wie α-Hydroxymethylbenzoin-methylether; oder α-Methylbenzoin und dessen Ether.

Eine weitere Gruppe von bevorzugten Photoinitiatoren bzw. -sensibilisatoren sind Benzil und Benzil-Derivate, insbesondere Benzilmonoketale, wie sie beispielsweise in den deutschen Auslegeschriften 2232365, 2261383, 2337183 oder 2616382 beschrieben sind. Hierzu gehören insbesondere Benzildimethylketal, Benzilmethylethylketal und Benzilmethylbenzylketal.

Sehr geeignete und vorteilhafte Photoinitiatoren bzw. -sensibilisatoren sind auch die beispielsweise in den deutschen Offenlegungsschriften 2830927, 2909994, 3020092, 3034697, 3114341 und 3133419 beschriebenen Acylphosphinverbindungen. Beispielhaft hierfür seien genannt das 2,4,6--Trimethylbenzoyldiphenylphosphinoxid, der 2,4,6--Trimethylbenzoylphenylphosphinsäureethylester und das 2,4,6-Trimethylbenzoylbis(o-tolyl)phosphinoxid.

Als Beispiele für weitere geeignete Photoinitiatoren bzw. -sensibilisatoren seien die Derivate des α-Hydroxyacetophenons erwähnt, wie sie z.B. in der DE-A-2808459, der DE-A-2722264 und der EP--A-3002 beschrieben sind. Hierzu gehören unter anderem 1-Phenyl-2-hydroxy-2-methyl-1-propanon, 1-(p-Isopropylphenyl)-2-hydroxy-2-methyl-1-propanon und 1-Hydroxy-1-benzoyl-cyclohexan. Geeignete Photoinitiatoren bzw. -sensibilisatoren sind ferner Benzophenon, Fluorenon, Anthrachinon, Xanthon, Thioxanthon und Acridon sowie Derivate dieser Verbindungen, wie sie z.B. in der DE-A-2003122, der DE-A-2122036, der DE-A-2811755, der EP-A--33721 und der US-PS 3759807 beschrieben sind, wobei hierunter besonders 2-Methylthioxanthon, 2-Chlorthioxanthon, 2-Isopropylthioxanthon und 2-tert.-Butylthioxanthon sowie Mischungen aus 2--Methyl- und 4-Methyl-thioxanthon und aus 2-Isopropyl- und 4-Isopropyl-thioxanthon bevorzugt sind.

In der erfindungsgemässen photopolymerisierbaren Mischungen können ein oder auch mehrere Photoinitiatoren bzw. -sensibilisatoren (b) enthalten sein. Die Menge an Photoinitiator bzw. -sensibilisator (b) beträgt dabei im allgemeinen 0,01 bis 20 Gew.-%, vorzugsweise 0,1 bis 10 Gew.-%, bezogen auf die photopolymerisierbaren, olefinisch ungesättigten Verbindungen (a). Das Verhältnis von Photoinitiator bzw. -sensibilisator (b) zu Aktivator (c) liegt im allgemeinen im Bereich von 0,1 bis 10. Üblicherweise werden die Aktivatoren (c) in solchen Mengen

eingesetzt, die dem 0,5 bis 5fachen des Gewichtes an Photoinitiator bzw. -sensibilisator (b) entsprechen.

Die erfindungsgemässen photopolymerisierbaren Mischungen enthalten als weitere wesentliche Komponente mindestens eine photopolymerisierbare, olefinisch ungesättigte Verbindung (a). Hierbei sind grundsätzlich alle Verbindungen mit mindestens einer olefinischen C-C-Mehrfachbindung geeignet, die im Gemisch mit dem Photoinitiator bzw. -sensibilisator und dem Aktivator zu einer Polymerisation angeregt werden können. Sehr geeignet sind dabei beispielsweise polymerisierbare Verbindungen mit solchen C-C-Doppelbindungen, die durch z.B. Aryl-, Carbonyl-, Amid-, Ester-, Carboxy- oder Nitril-Gruppen, Halogenatome oder C-C-Doppel- oder C-C-Dreifachbindungen aktiviert sind. Die photopolymerisierbaren, olefinisch ungesättigten Verbindungen (a) können sowohl niedermolekular als auch hochmolekular sein, sie können monofunktionell oder auch bi- oder polyfunktionell sein, d.h. eine oder mehrere photopolymerisierbare, olefinische Doppelbindungen im Molekül enthalten. Die photopolymerisierbaren, olefinisch ungesättigten Verbindungen (a) können in den erfindungsgemässen photopolymerisierbaren Mischungen allein oder im Gemisch miteinander oder auch im Gemisch mit weiteren an sich bekannten und üblichen Zusatzstoffen, wie beispielsweise gesättigten und/oder ungesättigten polymeren Bindemitteln, vorliegen. Ganz allgemein lassen sich alle für die Herstellung von photopolymerisierbaren Mischungen der in Rede stehenden Art bekannten und üblichen Monomeren, Oligomeren und/oder ungesättigten Polymeren verwenden, wobei deren Art und Auswahl sich insbesondere nach dem Verwendungszweck der photopolymerisierbaren Mischung richtet und dem Fachmann geläufig ist. Vorzugsweise sind in den photopolymerisierbaren Mischungen als Komponente (a) Verbindungen mit 2 oder mehr olefinischen photopolymerisierbaren Doppelbindungen oder Mischungen hiervon mit Verbindungen mit nur einer olefinischen photopolymerisierbaren Doppelbindung enthalten. Zur Steuerung der Viskosität der photopolymerisierbaren Mischung ist es häufig zweckmässig, eine höherviskose, hochmolekulare ungesättigte und/oder gesättigte Verbindung mit einer oder mehreren niedermolekularen, photopolymerisierbaren, olefinisch ungesättigten Verbindungen zu mischen.

Zu den niedermolekularen, photopolymerisierbaren, olefinisch ungesättigten Verbindungen (a) gehören beispielsweise die Vinylverbindungen, wie Vinylether, Vinylester, Styrol, Vinyltoluol, Vinylchlorid, Vinylidenchlorid, Vinylketone, Vinylsulfone, N-Vinylpyrrolidon, N-Vinylcaprolactam, N-Vinylcarbazol oder N,N'-Divinylharnstoffe, aber auch Allylester wie Diallylphthalat.

Besonders günstige niedermolekulare, olefinisch ungesättigte photopolymerisierbare Verbindungen (a) sind die α,β-olefinisch ungesättigten Mono- oder Dicarbonsäuren sowie insbesondere deren Derivate, z.B. Malein- oder Fumarsäurealkylester, insbesondere mit 1 bis 8 C-Atomen im Alkylrest, sowie besonders bevorzugt Acrylsäure und/oder Methacrylsäure und deren Derivate, wie (Meth)acrylnitril, (Meth)-acrylamid, N-Methylol-(meth)acrylamid sowie die Ester der Acrylsäure und/oder Methacrylsäure mit ein- oder mehrwertigen Alkoholen. Hierzu gehören beispielsweise die Di- und Poly-(meth)acrylate von Alkylenglykolen, Polyalkylenglykolen und mehrwertigen Alkanolen mit 2 bis 20 C-Atomen, wie die Di- und Poly(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, Neopentylglykol(2,2-Dimethylpropandiol), 1,4-Butandiol, 1,1,1-Trimethylolpropan, Glycerin oder Pentaerythrit; ferner die Monoacrylate und Monomethacrylate solcher Diole und Polyole, wie z.B. Ethylenglykol-, Di-, Tri- oder Tetraethylenglykolmono(meth)acrylat, 1,4-Butandiol-mono(meth)acrylat oder Hexandiol-mono(meth)acrylat, die (Meth)acrylate von Monoalkanolen mit 1 bis 20 C-Atomen, wie Methyl(meth)-acrylat, Ethyl(meth)acrylat, Propyl(meth)acrylat, Butyl(meth)acrylat, Hexyl(meth)acrylat oder 2-Ethylhexyl(meth)acrylat; sowie Monomere oder Oligomere mit 2 oder mehr acrylischen Doppelbindungen, die Urethangruppen und/oder Amidgruppen enthalten.

Als photopolymerisierbare, olefinisch ungesättigte, höhermolekulare Verbindungen sind vorzugsweise zu nennen: Epoxidacrylate, vorzugsweise mit einem Molekulargewicht zwischen 200 und 1500, wie sie beispielsweise erhalten werden durch Umsetzung von Acrylsäure und/oder Methacrylsäure mit aromatischen und/oder aliphatischen Diglycidylethern, z.B. solchen auf Basis von Bisphenol A, Butandiol, Pentaerythrit oder Neopentylglykol, oder mit epoxidierten Polybutadienen oder Leinsamenölen; Polyesteracrylate, wie sie beispielsweise hergestellt werden können durch Umsetzung von Hydroxylgruppen-haltigen gesättigten Polyestern mit Acryl- und/oder Methacrylsäure; und Urethanacrylate, insbesondere mit einem Molekulargewicht zwischen 200 und 4000, wie sie beispielsweise hergestellt werden können durch Umsetzung von Hydroxyalkyl(meth)acrylaten (wie Hydroxyethyl-(meth)acrylat, Hydroxypropyl-(meth)acrylat oder Butandiol-mono(meth)acrylat) mit vorzugsweise aliphatischen oder cycloaliphatischen Diisocyanaten (z.B. Hexamethylendiisocyanat oder Isophorondiisocyanat) und gegebenenfalls Polyolen als Kettenverlängerern (z.B. niedermolekularen Alkandiolen, Polyalkylenglykolen, hydroxylgruppenhaltigen Polyestern oder hydroxylgruppenhaltigen Polyacrylaten).

Als photopolymerisierbare, olefinisch ungesättigte Verbindungen (a) kommen auch polymere Verbindungen in Betracht, wie beispielsweise ungesättigte Polyester, hergestellt aus α,β-ungesättigten Dicarbonsäuren, wie Maleinsäure, Fumarsäure oder Itaconsäure, gegebenenfalls im Gemisch mit gesättigten aliphatischen bzw. aromatischen Dicarbonsäuren wie Adipinsäure, Phthalsäure, Terephthalsäure oder Tetrahydrophthalsäure, durch Umsetzung mit Alkandiolen wie Ethylenglykol, Propylenglykol, Butandiol, Neopentylglykol oder oxalkyliertem Bisphenol-A; ungesättigte Aminoplastharze, wie sie beispielsweise durch Umsetzung von gegebenenfalls veretherten Aminoplasten, wie Melamin/Formaldehyd- oder Harnstoff/Formaldehyd-Kondensationsprodukten, mit Hydroxyalkylacrylaten erhalten werden können; Butadien- und/oder Isopren-Polymerisate, vinylgruppenhaltige Polyurethane, Diallylphthalat-Präpolymere oder auch modifizierte Polyvinylalkohole mit photopolymerisierbaren, olefinisch ungesättigten Seitengruppen, wie beispielsweise vinylgruppenhaltige Polyvinylalkohole oder acryloierte und/oder methacryloierte Polyvinylalkohole.

Wie bereits erwähnt, können den photopolymerisierbaren, olefinisch ungesättigten Verbindungen (a) weitere gesättigte und/oder ungesättigte Verbindungen, insbesondere gesättigte und/oder ungesättigte Polymere, zugesetzt sein. Als Beispiele für polymere Bindemittel, die neben den photopolymerisierbaren, olefinisch ungesättigten Verbindungen (a) in den erfindungsgemässen Mischungen enthalten sein können, seien genannt: gesättigte oder ungesättigte Polyester, Polyacrylate und Polymethacrylate, Polyurethane, wie Polyetherurethane und Polyesterurethane, lineare Polyamide und besonders alkohollösliche Copolyamide, Cellulosederivate, Polyvinylalkohole sowie Polymere und Copolymere von Vinylestern aliphatischer Monocarbonsäuren mit 1 bis 4 C-Atomen, insbesondere von Vinylacetat und Vinylpropionat, mit unterschiedlichem Verseifungsgrad, Homo- und Copolymerisate von konjugierten aliphatischen Dienen, insbesondere Butadien- und/oder Isopren-Polymerisate, die als Comonomere insbesondere Styrol, Acrylnitril oder (Meth)acrylsäureester enthalten können, Styrol/Maleinsäureanhydrid- oder Styrol/Maleinsäure(halb)ester-Copolymerisate, Styrol/Maleinsäureanhydrid/(Meth)acrylsäure-Copolymerisate, Polyether, Polyharnstoffe, Polyimide und ähnliche. Zumindest in solchen photopolymerisierbaren Mischungen, die zur Herstellung von Systemen der optischen Informationsfixierung, insbesondere für die Herstellung von Photopolymerdruckplatten oder Resistmustern, eingesetzt werden sollen, sollen die neben den photopolymerisierbaren, olefinisch ungesättigten Verbindungen (a) in den photopolymerisierbaren Mischungen enthaltenen gesättigten und/oder ungesättigten Verbindungen, insbesondere die polymeren Bindemittel, mit den photopolymerisierbaren Verbindungen (a) verträglich sein.

Ferner können in den erfindungsgemässen photopolymerisierbaren Mischungen weitere Zusatz- und/oder Hilfsstoffe enthalten sein, wie Inhibitoren gegen die thermische Polymerisation, hautbildende Stoffe, wie Paraffine, anorganische und/oder organische Pigmente, Farbstoffe, anorganische und/oder organische Füllstoffe, Verlaufshilfsmittel wie Silikonöle, Mattierungs- oder Gleitmittel wie Wachse, Stabilisatoren gegen den thermischen oder photochemischen Abbau, Verstärkungsmittel, oder organische Lösungsmittel wie Alkohole, Kohlenwasserstoffe oder Ketone.

Art und Menge der weiteren Zusatz- und/oder Hilfsstoffe (d) hängen von dem jeweiligen Verwendungszweck der photopolymerisierbaren Mischungen ab und sind dem Fachmann hinlänglich bekannt.

Die erfindungsgemässen photopolymerisierbaren Mischungen eignen sich beispielsweise zur Herstellung von lichthärtbaren Lacken und zum Herstellen von Überzügen, insbesondere mit einer Schichtdicke von 2 bis 400 µm, auf beliebigen Substraten, wie Metallen, Holz, Kunststoffen, Glas, Papier oder Pappe. Die Überzüge können als Schutzschichten oder zu Dekorationszwecken dienen. Sehr geeignete photopolymerisierbare Mischungen für diesen Zweck enthalten z.B.: 0 bis 100 Gew.-%, vorzugsweise 30 bis 60 Gew.-%, bezogen auf die eingesetzten photopolymerisierbaren Verbindungen (a), einer höhermolekularen, photopolymerisierbaren, olefinisch ungesättigten Verbindung, 0 bis 100 Gew.-%, vorzugsweise 40 bis 70 Gew.-%, bezogen auf die eingesetzten photopolymerisierbaren Verbindungen (a), einer niedermolekularen, photopolymerisierbaren, olefinisch ungesättigten Verbindung, 0,1 bis 10 Gew.-%, vorzugsweise 1 bis 5 Gew.-%, bezogen auf die photopolymerisierbare Mischung, mindestens eines Photoinitiators, 1 bis 20 Gew.-%, vorzugsweise 2 bis 10 Gew.-%, bezogen auf die photopolymerisierbare Mischung, mindestens eines Aktivators sowie gegebenenfalls weitere übliche Zusatz- und/oder Hilfsmittel in an sich üblichen und bekannten Mengen.

Desweiteren sind die erfindungsgemässen photopolymerisierbaren Mischungen sehr vorteilhaft zur Herstellung von Systemen für die optische Informationsfixierung geeignet, insbesondere zur Herstellung von photopolymerisierbaren Aufzeichnungsmaterialien für die Herstellung von photopolymeren Druck- oder Reliefformen, wie Hochdruck-, Tiefdruck-, Offset- oder Siebdruck-Formen, und von Resistschichten oder Resistmustern, wie sie in der Ätz- oder Galvanotechnik oder auch zur Herstellung von Leiterplatten und gedruckten Schaltungen in der Dickschicht- und Dünnschicht-Technologie eingesetzt werden. Die auf einem dimensionsstabilen Träger aufgebrachte, lichtempfindliche, relief- oder resistbildende Schicht derartiger photopolymerisierbarer Aufzeichnungsmaterialien besteht dann vorteilhaft aus einer photopolymerisierbaren Mischung von, jeweils bezogen auf diese Mischung, 1 bis 60 Gew.-%, vorzugsweise 5 bis 40 Gew.-% an niedermolekularen, photopolymerisierbaren, olefinisch ungesättigten Verbindungen (a), 0,1 bis 10 Gew.-%, vorzugsweise 0,5 bis 5 Gew.-% mindestens eines Photoinitiators (b), 0,01 bis 10 Gew.-%, vorzugsweise 0,5 bis 5 Gew.-%, mindestens eines Aktivators (c), 35 bis 98,9 Gew.-%, vorzugsweise 55 bis 93 Gew.-%, eines mit der photopolymerisierbaren Verbindung (a) verträglichen polymeren Bindemittels sowie gegebenenfalls weitern üblichen Zusatz- und/oder Hilfsstoffen in an sich üblichen und bekannten Mengen.

Schliesslich sind die erfindungsgemässen photopolymerisierbaren Mischungen auch für die Herstellung von UV-härtenden Druckfarben und Druckpasten zum Bedrucken von Blech, Papier oder Kunststoffen in Schichtdicken von 0,5 bis 10 µm sowie zur Herstellung von Formkörpern und Imprägnierungen geeignet, wobei im Fall der beiden letztgenannten Anwendungen die photopolymerisierbaren Mischungen grundsätzlich die gleiche Zusammensetzung haben können wie vorstehend für die Herstellung von Überzügen erwähnt.

Als Strahlungsquellen für die Härtung und Photopolymerisation der erfindungsgemässen Mischungen kommen alle Strahlungsquellen in Betracht, die aktinisches Licht im Wellenlängenbereich von 230 bis 450 nm, vorzugsweise im Wellenlängenbereich von 300 bis 420 nm, aussenden bzw. einen ausreichend hohen Anteil von Licht dieses Wellenlängenbereiches emittieren. Insbesondere werden solche Strahlungsquellen herangezogen, deren Emissionsmaxima auf den Absorptionsbereich der in den photopolymerisierbaren Mischungen enthaltenen Photoinitiatoren bzw. -sensibilisatoren (b) und Aktivatoren (c) abgestellt ist. Bevorzugte Strahlungsquellen sind Quecksilberdampflampen sowie superaktinische Leuchtstoffröhren oder Impulsstrahler. Die Lampen können gegebenenfalls dotiert sein.

Die Erfindung sowie die mit den erfindungsgemässen photopolymerisierbaren Mischungen erzielbaren Vorteile werden durch die nachfolgenden Beispiele und Vergleichsversuche weiter erläutert. Die in den Beispielen und Vergleichsversuchen genannten Teile und Prozente beziehen sich, soweit nicht anders angegeben, auf das Gewicht.

*Beispiel 1 und Vergleichsversuche A1 bis A9*

Es wurden photopolymerisierbare Mischungen aus folgenden Bestandteilen hergestellt:

59 Teile eines Umsetzungsproduktes aus Bisphenol-A-Diglycidylether mit zwei Äquivalenten Acrylsäure
41 Teile Hexan-1,6-diol-diacrylat
1 Teil Benzildimethylketal
2 Teile Benzophenon

sowie jeweils einem der nachfolgend genannten Amin-Aktivatoren in den in der Tabelle 1 angegebenen Mengen.

Beispiel 1 (erfindungsgemäss): 3-Dimethylamino-2,2-dimethylpropanol-1
Vergleich A1: Methyldiethanolamin
Vergleich A2: Ethyldiethanolamin
Vergleich A3: Isopropyldiethanolamin
Vergleich A4: Isobutyldiethanolamin
Vergleich A5: Butyldiethanolamin
Vergleich A6: Cyclohexyldiethanolamin
Vergleich A7: 3-Dimethylaminopropanol
Vergleich A8: p-Dimethylaminobenzoesäureethylester (EP-A-3872)
Vergleich A9: 2-Dimethylaminoethylbenzoat (EP-A-2625).

Die Zusatzmengen der Amin-Aktivatoren wurden so gewählt, dass sie in der photopolymerisierbaren Mischung jeweils in der gleichen molaren Konzentration, nämlich 0,025 Mol Amin-Aktivator pro kg der Gesamtmischung, enthalten waren.

Zur Messung der Reaktivität der homogenen photopolymerisierbaren Mischungen wurden diese in einer Schichtdicke von 15 µm auf eine Glasplatte aufgezogen und mit einer Quecksilberhochdrucklampe (Leistung: 100 W/cm Bogenlänge, Abstand 10 cm) gehärtet. Für die einzelnen Probe wurde die jeweilige Bestrahlungsdauer ermittelt, die zur Erzielung einer nagelharten, kratzfesten Oberfläche notwendig war. Diese Mindestbestrahlungsdauer ist in der nachfolgenden Tabelle 1 durch die maximale Transportbandgeschwindigkeit wiedergegeben, mit der die Proben unter Erzielung der kratzfesten Oberfläche unter der Lampe durchgezogen werden konnten. Eine zweite Charge von Proben wurde dem Härtungstest nach 14tägiger Lagerung bei 60°C unterworfen. Die Abnahme der maximal möglichen Transportgeschwindigkeit zur Erzielung einer gleich-kratzfesten Oberfläche ist ein Mass für den Reaktivitätsabfall der photopolymerisierbaren Mischungen bei der Lagerung. Ferner wurde die Viskosität der photopolymerisierbaren Mischungen vor und nach 7tägiger Lagerung bei 60°C ermittelt (Auslaufzeiten nach DIN 53211). Viskositätszunahmen dienen als Mass für unerwünschte Veränderungen der fertig formulierten photopolymerisierbaren Gemische bei der Lagerung. Die Ergebnisse sind in Tabelle 1 zusammengestellt.

*Tabelle 1*

| Beispiel bzw. Vergleichsversuch | Menge Amin (Teile) | Maximale Transportbandgeschwindigkeit in m/min | | | Viskosität (Auslaufzeiten in sec nach DIN 53211) | | |
|---|---|---|---|---|---|---|---|
| | | a) 1-2 h nach Aminzugabe | b) nach Aminzugabe 14 Tage bei 60°C gelagert | c) prozentuale Änderung b) gegen a) | a) 1-2 h nach Aminzusatz | b) nach Aminzugabe 7 Tage bei 60°C gelagert | c) prozentuale Änderung b) gegen a) |
| 1 (Erfindung) | 3,3 | 40 | 40 | 0 | 79 | 88 | + 11,4 |
| A1 | 3 | 60 | 25 | - 58,3 | 88 | 160 | + 81,8 |
| A2 | 3,5 | 65 | 30 | - 53,8 | 86 | 99 | + 15,1 |
| A3 | 3,7 | 55 | 25 | - 36,4 | 85 | 85 | 0 |
| A4 | 4,0 | 45 | 30 | - 33,3 | 86 | 85 | 0 |
| A5 | 4,0 | 55 | 25 | - 54,5 | 85 | 90 | + 5,9 |
| A6 | 4,7 | 40 | 20 | - 50,0 | 96 | 96 | 0 |
| A7 | 2,6 | 30 | 25 | - 16,7 | 92 | 226 | + 145,7 |
| A8 | 4,9 | 30 | 30 | 0 | 85 | 84 | 0 |
| A9 | 4,9 | 35 | 35 | 0 | 88 | 163 | + 85,2 |

Die Daten in Tabelle 1 zeigen, dass bei den Vergleichsversuchen A1 bis A6 zwar sofort nach Zugabe des Aktivators höhere bzw. gleich hohe Härtungsgeschwindigkeiten erreicht werden konnten, jedoch sanken diese Härtungsgeschwindigkeiten bei Lagerung stark ab. Demgegenüber führt der Zusatz des erfindungsgemässen Aktivators zu keiner lagerungsbedingten Verminderung der Härtungsgeschwindigkeit, so dass nach 14tägiger Lagerung der photopolymerisierbaren Mischungen erheblich höhere Härtungsgeschwindigkeiten als bei den Vergleichsversuchen A1 bis A6 resultieren. Im Vergleich zu den Vergleichsversuchen A7 bis A9 besitzen die erfindungsgemässen Gemische sowohl bereits vor als auch nach der Lagerung eine höhere Härtungsgeschwindigkeit.

*Beispiel 2 und Vergleichsversuche B1 bis B9*

Es wurden verschiedene photopolymerisierbare Mischungen entsprechend Beispiel 1 und den Vergleichsversuchen A1 bis A9 hergestellt. Zur Prüfung des Ausschwitzens von Bestandteilen aus den Mischungen und der Wetterbeständigkeit der mit diesen Mischungen hergestellten gehärteten Überzüge wurden die photopolymerisierbaren Mischungen in einer Schichtdicke von 100 µm auf Kunstdruckpapier aufgerakelt; zur Prüfung der Vergilbung der hiermit hergestellten gehärteten Überzüge wurden die Mischungen in gleicher Schichtdicke auf weisses Photopapier aufgerakelt. Die so hergestellten härtbaren Beschichtungen wurden mit der gleichen Lampe wie in Beispiel 1 bei einer Transportbandgeschwindigkeit von 10 m/min gehärtet. Das Ausschwitzen der Aktivatoren aus den gehärteten Schichten wurde gemäss DIN 53230 visuell nach 3- und 21tägiger Lagerung bei 23°C beurteilt. Die Wetterbeständigkeit der gehärteten Schichten wurde nach 1000-stündiger Kurzbewitterung in einen Atlas W60 Weatherometer in einer Skala von 0 bis 5 bewertet. Als Mass für die Vergilbung der erhaltenen gehärteten Überzüge wurde der Weissgrad nach Berger bestimmt. Die erhaltenen Messwerte sind in der Tabelle 2 zusammengestellt.

*Tabelle 2*

| Beispiel bzw. Vergleichsversuch | | Ausschwitzen nach Lagerung bei 23°C nach 3 d | nach 21 d | Wetterbeständigkeit | Vergilbung (Weissgrad nach Berger) |
|---|---|---|---|---|---|
| Beispiel | 2 | 0 | 1 - 2 | 1 | 83 |
| Vergleich | B1 | 3 - 4 | 4 | 1 - 2 | 83 |
| | B2 | 3 - 4 | 4 | 2 | 84 |
| | B3 | 3 - 4 | 4 | 1 - 2 | 84 |
| | B4 | 2 | 4 | 3 | 82 |
| | B5 | 0 | 4 | 2 - 3 | 83 |
| | B6 | 0 | 0 | 2 | 80 |
| | B7 | 4 | 4 | 4 | 80 |
| | B8 | 0 | 0 | 5 | 50 |
| | B9 | 0 | 0 | 1 - 2 | 69 |

Tabelle 2 zeigt, dass der erfindungsgemässe Aktivator weit weniger aus den gehärteten Schichten ausschwitzt als die Amine der Vergleichsversuche B1 bis B5 und B7. Die Amine der Vergleichsversuche B8 und B9 schwitzen zwar nicht aus, dafür zeigen jedoch die hiermit hergestellten gehärteten Überzüge eine geringere Wetterbeständigkeit und eine deutlich stärkere Vergilbung. Aus beiden Tabellen 1 und 2 wird deutlich, dass die erfindungsgemässen Mischungen in ihrer Eigenschaftskombination den Vergleichsprodukten überlegen sind.

*Beispiel 3 und Vergleichsversuch C*

Beispiel 1 und Vergleichsversuch A1 wurden wiederholt, anstelle von Benzildimethylketal und Benzophenon wurden diesmal jedoch als Photoinitiator 1,5 Teile 2-Methylthioxanthon eingesetzt. Die Härtungsgeschwindigkeiten sowie die Reaktionsänderungen der photopolymerisierbaren Mischungen bei Lagerung sind der Tabelle 3 zu entnehmen.

*Beispiel 4 und Vergleichsversuch D*

Beispiel 1 und Vergleichsversuch A1 wurden wiederholt, diesmal jedoch auf den Zusatz von Benzophenon verzichtet, dafür der Anteil von Benzildimethylketal auf 2 Teile erhöht. Die mit diesen polymerisierbaren Gemischen ermittelten Härtungsgeschwindigkeiten und Reaktivitätsänderungen bei Lagerung sind ebenfalls in Tabelle 3 enthalten.

*Beispiel 5 und Vergleichsversuch E*

Beispiel 1 und Vergleichsversuch A1 wurden wiederholt, anstelle von Benzildimethylketal und Benzophenon wurden diesmal jedoch 2 Teile 1-Phenyl-2--hydroxi-2-methylpropanon als Initiator zugesetzt. Die erzielten Ergebnisse sind in Tabelle 3 wiedergegeben.

*Tabelle 3*

| Beispiel bzw. Vergleichsversuch | Maximale Transportgeschwindigkeiten in m/min a) 1-2 h nach Aminzugabe | b) nach Aminzugabe 7 Tage bei 60°C gelagert | c) prozentuale Änderung b) gegen a) |
|---|---|---|---|
| C | 70 | 25 | - 64,3 |
| 3 | 45 | 45 | 0 |
| D | 20 | 15 | - 25,0 |
| 4 | 15 | 15 | 0 |
| E | 30 | 20 | - 33,3 |
| 5 | 20 | 25 | + 20,0 |

**Patentansprüche**

1. Photopolymerisierbare Mischung, enthaltend
(a) mindestens eine Verbindung mit mindestens einer photopolymerisierbaren, olefinisch ungesättigten Doppelbindung,
(b) mindestens einen Photoinitiator bzw. -sensibilisator,
(c) ein oder mehrere tertiäre Amine als Aktivator, sowie gegebenenfalls
(d) weitere übliche Zusatz- und/oder Hilfsstoffe,
dadurch gekennzeichnet, dass die Mischung als Aktivator (c) ein tertiäres Amin der allgemeinen Formel (I)

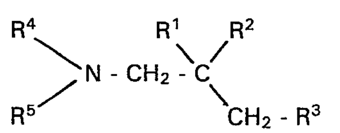 (I)

enthält, worin stehen

$R^1$, $R^2$: unabhängig voneinander für einen gegebenenfalls hydroxyl- oder alkoxy-substituierten niederen Alkylrest, einen gegebenenfalls hydroxyl- oder alkoxy-substituierten Cycloalkylrest, einen gegebenenfalls alkyl- oder alkoxy-substituierten Phenylrest, eine Hydroxylgruppe oder eine niedere Alkoxygruppe oder $R^1$ und $R^2$ gemeinsam unter cyclischer Verknüpfung für einen Alkylenrest;

$R^3$: für einen Rest mit der Bedeutung von $R^1$ oder $R^2$, ein Wasserstoffatom, einen gesättigten oder ungesättigten Acyloxy-Rest oder einen alkyl-, alkoxy-, halogen- und/oder dialkylamino-substituierten Benzoyloxyrest; sowie

$R^4$, $R^5$: unabhängig voneinander für einen gegebenenfalls hydroxyl-substituierten niederen Alkylrest, einen gegebenenfalls hydroxyl-substituierten Cycloalkylrest oder einen gegebenenfalls alkyl- oder alkoxy-substituierten Phenylrest oder $R^4$ und $R^5$ gemeinsam unter cyclischer Verknüpfung für einen Alkylenrest oder einen Alkylenoxialkylenrest.

2. Photopolymerisierbare Mischung gemäss Anspruch 1, dadurch gekennzeichnet, dass der Aktivator (c) eine Verbindung der allgemeinen Formel (I) mit den Substituenten $R^1 = R^2 = CH_3$, $R^3 = OH$ und $R^4 = R^5 =$ 2-Hydroxyethyl oder 2-Hydroxypropyl ist.

3. Photopolymerisierbare Mischung gemäss Anspruch 1, dadurch gekennzeichnet, dass als Aktivator (c) 1-Hydroxy-2,2-dimethyl-3-dimethylaminopropan enthalten ist.

4. Photopolymerisierbare Mischungen nach einem der Ansprüche 1 bis 3, dadurch gekennzeichnet, dass der oder die Aktivatoren (c) in einer Menge von 0,1 bis 20 Gew.-%, bezogen auf die photopolymerisierbaren, olefinisch ungesättigten Verbindungen (a), enthalten sind.

5. Photopolymerisierbare Mischungen gemäss einem der Ansprüche 1 bis 4, dadurch gekennzeichnet, dass der oder die Photoinitiatoren bzw. -sensibilisatoren in einer Menge von 0,01 bis 20 Gew.-%, bezogen auf die photopolymerisierbaren, olefinisch ungesättigten Verbindungen (a), enthalten sind.

6. Photopolymerisierbare Mischungen gemäss einem der Ansprüche 1 bis 5, dadurch gekennzeichnet, dass das Gewichtsverhältnis von Photoinitiator bzw. -sensibilisator (b) zu Aktivator (c) in der photopolymerisierbaren Mischung im Bereich von 1:10 bis 10:1 liegt.

7. Photopolymerisierbare Mischungen gemäss einem der Ansprüche 1 bis 6, dadurch gekennzeichnet, dass sie als Photoinitiator bzw. -sensibilisator (b) Benzoin, Benzoin-Derivate, Benzil und/oder Benzil-Derivate, insbesondere Benzilmonoketale, enthalten.

8. Photopolymerisierbare Mischungen gemäss einem der Ansprüche 1 bis 6, dadurch gekennzeichnet, dass sie als Photoinitiator bzw. -sensibilisator (b) Acetophenon, Benzophenon, Fluorenon, Anthrachinon, Xanthon, Thioxanthon, Acridon oder Derivate dieser Verbindungen enthalten.

9. Photopolymerisierbare Mischungen gemäss einem der Ansprüche 1 bis 6, dadurch gekennzeichnet, dass sie als Photoinitiator bzw. -sensibilisator (b) Acylphosphin-Verbindungen enthalten.

10. Photopolymerisierbare Mischungen gemäss einem der Ansprüche 1 bis 9, dadurch gekennzeichnet, dass als photopolymerisierbare, olefinisch ungesättigte Verbindungen (a) niedermolekulare Vinylverbindungen enthalten sind.

11. Photopolymerisierbare Mischungen nach einem der Ansprüche 1 bis 9, dadurch gekennzeichnet, dass als photopolymerisierbare, olefinisch ungesättigte Verbindungen (a) niedermolekulare oder

höhermolekulare Verbindungen von α,β-olefinisch ungesättigten Carbonsäuren, insbesondere von Acryl- und/oder Methacrylsäure, enthalten sind.

12. Photopolymerisierbare Mischungen gemäss Anspruch 11, dadurch gekennzeichnet, dass als Verbindung (a) Polyester(meth)acrylate, Epoxid(meth)-acrylate und/oder Urethan(meth)acrylate enthalten sind.

13. Photopolymerisierbare Mischungen nach einem der Ansprüche 1 bis 12, dadurch gekennzeichnet, dass sie neben den photopolymerisierbaren, olefinisch ungesättigten Verbindungen (a) gesättigte und/oder ungesättigte polymere Bindemittel enthalten.

14. Verwendung der photopolymerisierbaren Mischungen nach einem der Ansprüche 1 bis 13 zur Herstellung von Überzügen.

15. Verwendung der photopolymerisierbaren Mischungen nach einem der Ansprüche 1 bis 13 zur Herstellung von Systemen für die optische Informationsfixierung, insbesondere Druck- oder Reliefformen, Resistschichten oder Resistmustern.

16. Verwendung der photopolymerisierbaren Mischungen gemäss einem der Ansprüche 1 bis 13 zur Herstellung von UV-härtenden Druckfarben, Formkörpern oder Imprägnierungen.

**Claims**

1. A photopolymerizable mixture, containing

(a) at least one compound possessing at least one photopolymerizable, olefinically unsaturated double bond,

(b) at least one photoinitiator or photosensitizer,

(c) at least one tertiary amine as activator and, if desired,

(d) other conventional additives and/or assistants,

wherein the mixture contains, as activator (c), a tertiary amine of the general formula (I)

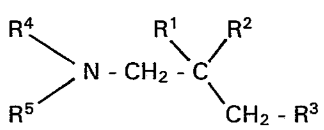

(I)

where

$R^1$ and $R^2$ independently of one another are unsubstituted, hydroxyl-substituted or alkoxy-substituted lower alkyl; unsubstituted, hydroxyl-substituted or alkoxy-substituted cycloalkyl; unsubstituted, alkyl-substituted or alkoxy-substituted phenyl; or lower alkoxy, or $R^1$ and $R^2$ are bonded together to form a cyclic alkylene radical,

$R^3$ has the same meaning as $R^1$ or $R^2$ or is hydrogen or saturated or unsaturated acyloxy, or is benzoyloxy which is substituted by alkyl, alkoxy, halogen and/or dialkylamino, and

$R^4$ and $R^5$ independently of one another are unsubstituted or hydroxyl-substituted lower alkyl; unsubstituted or hydroxyl-substituted cycloalkyl; or unsubstituted, alkyl-substituted or alkoxy-substituted phenyl, or $R^4$ and $R^5$ are bonded together to form a cyclic alkylene radical or a cyclic alkyleneoxyalkylene radical.

2. A photopolymerizable mixture as claimed in claim 1, wherein the activator (c) is a compound of the general formula (I), where $R^1$ and $R^2$ are each $CH_3$, $R^3$ is OH and $R^4$ and $R^5$ are each 2-hydroxyethyl or 2-hydroxypropyl.

3. A photopolymerizable mixture as claimed in claim 1, which contains 1-hydroxy-2,2-dimethyl--3-dimethylaminopropane as the activator (c).

4. A photopolymerizable mixture as claimed in any of claims 1 to 3, wherein the activator or activators (c) is/are present in an amount of from 0.1 to 20% by weight, based on the photopolymerizable, olefinically unsaturated compound (a).

5. A photopolymerizable mixture as claimed in any of claims 1 to 4, wherein the photoinitiator or photosensitizer, or the photoinitiators or photosensitizers, is/are present in an amount of from 0.01 to 20% by weight, based on the photopolymerizable, olefinically unsaturated compound (a).

6. A photopolymerizable mixture as claimed in any of claims 1 to 5, wherein the weight ratio of the photoinitiator or photosensitizer (b) to the activator (c) in the photopolymerizable mixture is from 1:10 to 10:1.

7. A photopolymerizable mixture as claimed in any of claims 1 to 6, which contains benzoin, a benzoin derivative, benzil and/or a benzil derivative as the photoinitiator or photosensitizer (b).

8. A photopolymerizable mixture as claimed in any of claims 1 to 6, which contains acetophenone, benzophenone, fluorenone, anthraquinone, xanthone, thioxanthone, acridone or a derivative of these compounds as the photoinitiator or photosensitizer (b).

9. A photopolymerizable mixture as claimed in any of claims 1 to 6, which contains an acylphosphine compound as the photoinitiator or photosensitizer (b).

10. A photopolymerizable mixture as claimed in any of claims 1 to 9, which contains a low molecular weight vinyl compound as the photopolymerizable, olefinically unsaturated compound (a).

11. A photopolymerizable mixture as claimed in any of claims 1 to 9, which contains a low molecular weight or high molecular weight compound of an α,β-olefinically unsaturated carboxylic acid, especially acrylic and/or methacrylic acid, as the photopolymerizable, olefinically unsaturated compound (a).

12. A photopolymerizable mixture as claimed in claim 11, which contains a polyester(meth)acrylate, an epoxide(meth)acrylate and/or a urethane(meth)-acrylate as the compound (a).

13. A photopolymerizable mixture as claimed in any of claims 1 to 12, which contains a saturated and/or unsaturated polymeric binder in addition to the photopolymerizable, olefinically unsaturated compound (a).

14. The use of a photopolymerizable mixture as claimed in any of claims 1 to 13 for the production of coatings.

15. The use of a photopolymerizable mixture as claimed in any of claims 1 to 13 for the production of

systems for the optical fixation of information, especially printing plates or relief plates, resist layers or resist patterns.

16. The use of a photopolymerizable mixture as claimed in any of claims 1 to 13 for the production of UV-curable printing inks, moldings or impregnations.

**Revendications**

1. Mélange photopolymérisable, comprenant:
(a) au moins un composé avec au moins une double liaison à insaturation oléfinique photopolymérisable,
(b) au moins un photo-initiateur ou photo-sensibilisateur,
(c) une ou plusieurs amines tertiaires servant de substances activatrices et éventuellement
(d) d'autres additifs et/ou adjuvants usuels,
caractérisé en ce que le mélange contient en tant qu'activateur (c) une amine tertiaire de la formule générale (I)

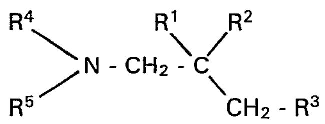

(I)

dans laquelle

$R^1$ et $R^2$ désignent chacun, indépendamment l'un de l'autre, un radical alkyle inférieur éventuellement hydroxy- ou alcoxy-substitué, un groupe cycloalkyle éventuellement hydroxy- ou alcoxy-substitué, un groupe phényle éventuellement alkyl- ou alcoxy-substitué, un groupe hydroxyle ou un groupe alcoxy inférieur ou $R^1$ et $R^2$ forment ensemble un groupe alkylène faisant partie d'un cycle;

$R^3$ possède la signification définie pour $R^1$ et $R^2$ ou désigne un atome d'hydrogène, un groupe acyloxy saturé ou non saturé ou un groupe benzyloxy alkyl-, alcoxy-, halo- et/ou dialkylamino-substitué et

$R^4$ et $R^5$ désignent chacun, indépendamment l'un de l'autre, un radical alkyle inférieur éventuellement hydroxy-substitué, un groupe cycloalkyle éventuellement hydroxy-substitué ou un groupe phényle éventuellement alkyl- ou alcoxy-substitué
ou $R^4$ et $R^5$ forment ensemble un groupe alkylène ou alkylène-oxyalkylène faisant partie d'un cycle.

2. Mélange photopolymérisable suivant la revendication 1, caractérisé en ce que l'activateur (c) est choisi parmi les composés de la formule générale (I), dans laquelle $R^1=R^2=CH_3$, $R^3=OH$ et $R^4=R^5=$ hydroxy-2 éthyle ou hydroxy-2 propyle.

3. Mélange photopolymérisable suivant la revendication 1, caractérisé en ce que l'activateur (c) est l'hydroxy-1 diméthyl-2,2 diméthylamino-3 propane.

4. Mélanges photopolymérisables suivant l'une des revendications 1 à 3, caractérisés en ce qu'ils contiennent un ou des activateurs (c) en une proportion de 0,1 à 20% en poids par rapport aux composés à insaturation oléfinique photopolymérisables (a).

5. Mélanges photopolymérisables suivant l'une des revendications 1 à 4, caractérisés en ce qu'ils contiennent un ou des photo-initiateurs ou photo-sensibilisateurs en une proportion de 0,01 à 20% en poids par rapport aux composés à insaturation oléfinique photopolymérisables (a).

6. Mélanges photopolymérisables suivant l'une des revendications 1 à 5, caractérisés en ce que le rapport pondéral du photo-initiateur ou photo-sensibilisateur (b) à l'activateur (c) est compris entre 1:10 et 10:1 dans le mélange photopolymérisable.

7. Mélanges photopolymérisables suivant l'une des revendications 1 à 6, caractérisés en ce que les photo-initiateurs ou photo-sensibilisateurs (b) sont choisis parmi la benzoïne, les dérivés de la benzoïne, le benzile et/ou les dérivés du benzile.

8. Mélanges photopolymérisables suivant l'une des revendications 1 à 6, caractérisés en ce que les photo-initiateurs ou photo-sensibilisateurs (b) sont choisis parmi l'acétophénone, la benzophénone, la fluorénone, l'anthraquinone, la xanthone, la thioxanthone, l'acridone et les dérivés de ces substances.

9. Mélanges photopolymérisables suivant l'une des revendications 1 à 6, caractérisés en ce qu'ils contiennent comme photo-initiateur ou photo-sensibilisateur (b) des dérivés acyl-phosphiniques.

10. Mélanges photopolymérisables suivant l'une des revendications 1 à 9, caractérisés en ce que les composés à insaturation oléfinique photopolymérisables (a) sont choisis parmi les substances vinyliques à bas poids moléculaire.

11. Mélanges photopolymérisables suivant l'une des revendications 1 à 9, caractérisés en ce que les composés à insaturation oléfinique photopolymérisables (a) sont choisis parmi les dérivés d'acides carboxyliques à insaturation $\alpha,\beta$-oléfinique à bas poids moléculaire ou à poids moléculaire élevé, en particulier de l'acide acrylique et/ou de l'acide méthacrylique.

12. Mélanges photopolymérisables suivant la revendication 11, caractérisés en ce que le composé (a) est choisi parmi les (méth)acrylates de polyester, les (méth)acrylates d'époxyde et/ou les (méth)acrylates d'uréthanne.

13. Mélanges photopolymérisables suivant l'une des revendications 1 à 12, caractérisés en ce qu'ils contiennent, à côté des composés à insaturation oléfinique photopolymérisables (a) des liants polymères saturés et/ou non saturés.

14. Utilisation des mélanges photopolymérisables suivant l'une des revendications 1 à 13 pour la réalisation de revêtements.

15. Utilisation des mélanges photopolymérisables suivant l'une des revendications 1 à 13 pour la production de systèmes pour la fixation d'informations optiques, en particulier de formes d'impression ou en relief, de couches de réserve ou de clichés de réserve.

16. Utilisation des mélanges photopolymérisables suivant l'une des revendications 1 à 13 pour la production d'encres d'impression, d'éléments façonnés ou d'imprégnations durcissant sous l'action de la lumière ultra-violette.